(19) Europäisches Patentamt
European Patent Office
Office européen des brevets

(11) **EP 2 884 667 A1**

## (12) EUROPEAN PATENT APPLICATION

(43) Date of publication:
**17.06.2015 Bulletin 2015/25**

(51) Int Cl.:
*H03M 13/27* (2006.01)        *H04L 1/00* (2006.01)
*H04L 27/26* (2006.01)        *H04L 5/00* (2006.01)

(21) Application number: **13197238.2**

(22) Date of filing: **13.12.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Siemens Aktiengesellschaft**
**80333 München (DE)**

(72) Inventor: **Hulbert, Anthony Peter**
**Bassett Green, Southampton, Hampshire SO16 3DF (GB)**

(54) **High performance interleaving for OFDM**

(57)     A method for generating an optimized bit interleaver for OFDM is provided. The key idea is to spread as uniformly as possible the subcarrier positions assigned to S consecutive coded bits over the available frequency band, where S is the memory of the code. Starting from a randomly defined time/frequency interleaving pattern, an iterative algorithm is applied by first swapping randomly subcarrier assignments and secondly by computing a metric representative of said frequency distribution of the subcarriers assigned to S consecutive coded bits, until the ideal interleaving pattern is achieved.

FIG 2

**Description**

The present invention relates to a method of optimizing a spread of sub-carriers within an overall frequency band used to modulate a set of contiguous bits for transmission of a plurality of symbols. Furthermore, the present invention relates to an interleaving device for optimizing the spread of sub-carriers used to modulate a set of contiguous bits for transmission. Such interleaving device can be used in conjunction with an encoder for providing a convolutional code.

High spectral efficiency digital modulation in a multipath environment is commonly implemented using orthogonal frequency division multiplex. This approach divides the available bandwidth for transmission of the signal into a large number of equi-spaced sub-carriers, wherein the individual sub-carriers are modulated. In a frequency-selective fading multipath environment, some of the sub-carrier frequencies may experience deep fading. This fading is usually mitigated by the applications of forward error correction coding. This is usually accompanied by an interleaver whose purpose is to spread the positions of the errored bit throughout the code, thereby potentially greatly improving its performance. In many OFDM (Orthogonal Frequency Division Multiplex) applications the channel fading has low correlation across the frequencies while it may have relatively high correlation across the OFDM symbols, particularly if the ends of the link are static or moving slowly relative to the correlation distance of the channel (i.e. related to its wave length).

Interleavers are desirable that have a good spread of frequency over the "memory" of the code (usually relating to the length of the shift register of the encoder and the rate of the code) whilst providing reasonable time spread, particularly for irregular bursts. Such irregular bursts can arise, for example, when some OFDM symbols contain pilot (a priori known) sub-carriers and others do not.

Previous solutions to the above interleaver design have generally involved a measure of "hand crafting" and experimentation to find interleaver structures that provide characteristic that approximate to the requirement. This may be practical where only a small number of different burst structures are required. However, the process can become unwieldy where a large number of burst structures must be provided for.

In view of that the object of the present invention is to provide a method which allows for automatically generating an interleaver for any burst structure.

According to the present invention this object is solved by a method of optimizing a spread of sub-carriers within an overall frequency band used to modulate a set of contiguous bits for transmission of a plurality of symbols, the overall frequency band being divided into a pregiven number of consecutively positioned frequency sub-bands, and each sub-carrier being assigned to one of said frequency sub-bands, including

- step a: providing a plurality of symbol number/sub-carriers cells each assigned to a specific symbol number of said symbols and a specific one of said sub-carriers,
- step b: randomly assigning one of a pregiven number of bits to one of said symbol number/sub-carriers cells each, thus obtaining a first set of symbol number/sub-carriers cells for the pregiven number of bits, wherein each of said bits has its own specific position within the overall frequency band,
- step c: computing a first metric of spread of the positions of the bits within the overall frequency band for the first set of symbol number/sub-carriers cells,
- step d: swapping the symbol number/sub-carriers cell of one of said bits randomly with another one of said symbol number/sub-carriers cells thus obtaining a second set of symbol number/sub-carriers cells for the pregiven number of bits,
- step e: computing a second metric of spread of the positions of the bits within the overall frequency band for the second set of symbol number/sub-carriers cells,
- step f: using said second set of symbol number/sub-carriers cells if the second metric represents a more uniform spread of the sub-carriers within the overall frequency band than the first metric, otherwise using said first set of symbol number/sub-carriers cells.

Furthermore, according to the present invention there is provided an interleaving device for optimizing a spread of sub-carriers within an overall frequency band used to modulate a set of contiguous bits for transmission of a plurality of symbols, the overall frequency band being divided into a pregiven number of consecutively positioned frequency sub-bands, and each sub-carrier being assigned to one of said frequency sub-bands, the interleaving device being designed to carry out the following steps

- step a: providing a plurality of symbol number/sub-carriers cells each assigned to a specific symbol number of said symbols and a specific one of said sub-carriers,
- step b: randomly assigning one of a pregiven number of bits to one of said symbol number/sub-carriers cells each, thus obtaining a first set of symbol number/sub-carriers cells for the pregiven number of bits, wherein each of said bits has its own specific position within the overall frequency band,

- step c: computing a first metric of spread of the positions of the bits within the overall frequency band for the first set of symbol number/sub-carriers cells,
- step d: swapping the symbol number/sub-carriers cell of one of said bits randomly with another one of said symbol number/sub-carriers cells thus obtaining a second set of symbol number/sub-carriers cells for the pregiven number of bits,
- step e: computing a second metric of spread of the positions of the bits within the overall frequency band for the second set of symbol number/sub-carriers cells,
- step f: using said second set of symbol number/sub-carriers cells if the second metric represents a more uniform spread of the sub-carriers within the overall frequency band than the first metric, otherwise using said first set of symbol number/sub-carriers cells.

Advantageously the interleaving of the sub-carriers may be performed automatically wherein the spread of the sub-carriers over the total frequency band is optimized. This is accomplished by randomly assigning one of a pregiven number of bits to one of said symbol number/sub-carriers cells each, computing a metric of spread within the overall frequency band for the bits, swapping at least one of the sub-carriers and again computing the metric of spread. If the spread is better before swapping the originally organized symbol number/sub-carriers cells are taken. If not, the organization with the swapped sub-carrier is taken. Thus, the spread of the sub-carriers is optimized.

The steps c to f may be repeated once or several times. Each time these steps are repeated, a further optimization may take place.

According to a specific embodiment for computing the metrics of spread in steps c and e a set of regularly spaced reference frequencies is provided, the sub-carriers are positioned in a frequency ascending order and the respective metric is computed on the basis of a sum of values relating to distances, each distance representing the interval between one of said sub-carriers and a corresponding one of said reference frequencies. Such regularly spaced reference frequencies guarantee that the sub-carriers are spread over the spectrum uniformly.

The set of reference frequencies may be provided starting and/or ending with a gap to the respective edge of the overall frequency band. This means that the first reference frequency and the last reference frequency are not positioned directly at the edge of the overall frequency band. The advantage of such reference frequency structure is that the structure as such may be shifted for further optimization.

Additionally, for obtaining the sum of values a mean of all distances may be subtracted from each distance. Thus, the absolute position of the reference frequencies has less effect.

Moreover, for computing the metrics of spread in steps c and e a mean frequency of said overall frequency band may be provided and the metric may be computed on the basis of the standard deviation of the sub-carriers from the mean frequency. If the standard deviation is high, the distribution of the sub-carriers is also high. However, the uniformity of the spread may be less than in the above case where regularly spaced referenced frequencies are used. However, the use of the standard deviation only demonstrate that any metric of spread can be utilized for broadly positioning the sub-carriers in the total frequency band.

Specifically, a coding method may include one of the above methods, wherein each sub-carrier is assigned to a separate bit of a code, respectively. Thus, the inventive method of optimizing a spread of actually used sub-carriers can be employed for coding methods, specifically for convolutional codes.

The code may be used for OFDM modulation. Such modulation technique is widely spread in the field of data transmission, e.g. DSL-technique or DVB-T standard.

Convolutional codes have a so-called "memory". The method of the present invention can be used to obtain an optimized spread of sub-carriers over the memory of such code.

The present invention will now be explained in further detail by referring to the attached figures showing:

FIG 1    a diagram for computing metrics of spread for a plurality of entries in a code memory;
FIG 2    a frequency diagram of actually used frequencies for transmitting bits of a symbol;
FIG 3    a diagram of time/frequency indices and
FIG 4    the indices of FIG 3 randomly re-ordered.

The following embodiments are preferred examples of the present invention.

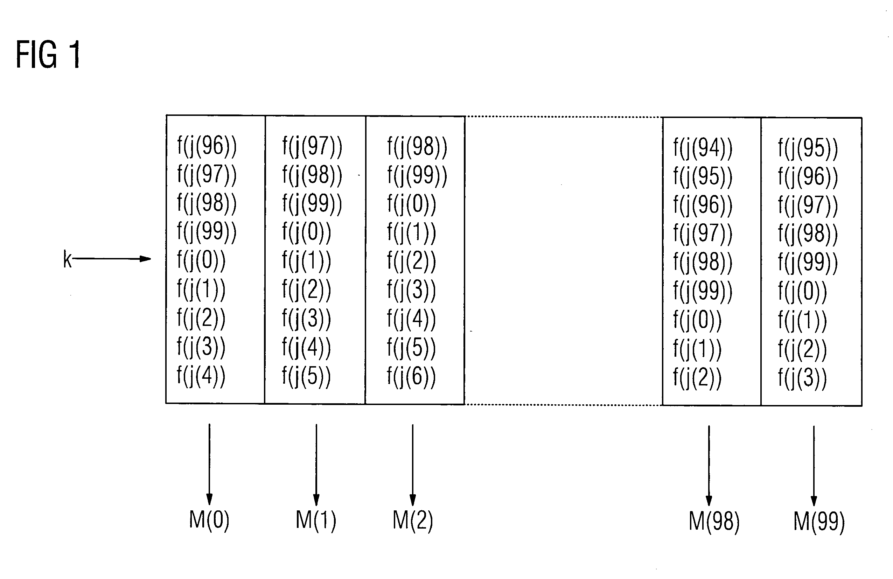

Commonly orthogonal frequency division multiplex (OFDM) is used for digital modulation in a multipath environment. A convolutional code may be employed for realizing the digital modulation. In the example of FIG 1 the convolutional code has a memory span S equal to 9. One column in FIG 1 represents the sub-carriers actually used for nine bits of a symbol time. Each column represents another symbol time.

In the present example the number of "symbol number/sub-carrier cells" is 100. Thus, for the convolutional code there are one hundred different symbol times. At symbol time "0" the shift register of the encoder includes bit "0" as well as bit "1" to bit "4" and bit "96" to bit "99". At bit time "1" the shift register includes bit "1" as well as bit "2" to bit "5" and bit "97" to bit "0". The further register entries at later symbol times may be depicted from FIG 1.

A frequency f (j(i)), specifically a sub-carrier, is assigned to each bit. The number "i" inside each of the frequency descriptors f (j(i)) is the index of the bits in the order that they preferably came out of a FEC (Forward Error Correction) encoder. Thus, for example, f (j(4)) is the sub-carrier frequency used to transmit the fifth encoded bit (fifth not fourth, because counting is started at zero). Function j represents a random function. This means that bit "0" is randomly assigned to number 34, for instance. Bit "1" may be randomly assigned to number 78. Function f represents a look up table, for instance. In the look up table each number is assigned to a specific frequency/sub-carrier.

For each symbol time k a metric of spread M (k) is calculated. The goal is now to spread the sub-carriers as uniformly as possible.

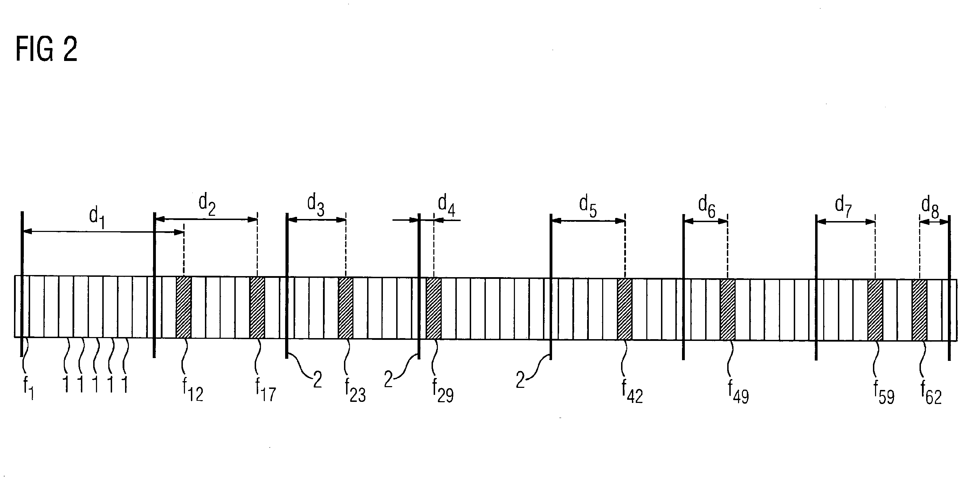

For this goal an interleaver is proposed which is generated by optimizing an initial interleaver that is generated randomly. The principle is to swap interleaver entries in order to improve the spread of frequencies over the memory of the code. This is accomplished by generating the metric for spread. This metric has an inverse relationship with the spread i.e. the better the spread, the smaller the metric. The generation of the metric is illustrated in FIG 2.

The diagram illustrates a case where 64 "symbol number/sub-carrier cells" 1 are available. All these symbol number/sub-carrier cells 1 are arranged in an overall frequency band available for transmission. Here the overall frequency band starts at minimum frequency sub-band $f_1$ and ends at maximum frequency sub-band $f_{64}$.

In the present example a spread of the symbol number/sub-carrier cells is desired over a memory period of 8 bits (the memory size of the code is not limited to 9 as in FIG 1 but may have any appropriate size, specifically 8 bits in the example of FIG 2).

At the specific symbol time of FIG 2 sub-carriers $f_{12}$, $f_{17}$, $f_{23}$, $f_{29}$, $f_{42}$, $f_{49}$, $f_{59}$ and $f_{62}$ are used for bit transmission. They represent the actually used frequencies at the present symbol time, i.e. for the actual symbol number.

A set of reference frequencies 2 has been set up, uniformly spaced, over the range of frequencies shown as vertical thick lines in FIG 2.

The bits are not generally associated with those frequencies in ascending order of frequency. Nevertheless, the metric for spread is computed preferably based on ascending order of frequency. For each actual frequency, i.e each sub-carrier, in turn, its distance, $d_i$, from a corresponding reference frequency in turn is computed i.e. beginning on the left side the distance of the first sub-carrier $f_{12}$ from the first reference frequency 2 (most left one) is $d_1$. The distance between the second sub-carrier $f_{17}$ to the second reference frequency 2 is $d_2$ etc.

In the present embodiment the metric for spread is based on the sum square of $d_i$. Other embodiments may use for example the standard deviation from a mean frequency as metric for spread. A refinement subtracts the mean of $d_i$ before performing the sum square. It is straightforward to appreciate that a low value of the metric indicates that the frequencies are well spread over the range of the frequencies, whereas a high value indicates a clustering of frequencies. The basic principle is to generate the metrics for bits around every bit position and search for the largest metric. Interleaver positions related to that bit position are swapped with randomly selected alternative bit positions. If the overall largest metric reduces, the swap is accepted. If not, the status quo is restored.

A specific algorithm for optimizing a spread of actually used sub-carriers is presented in more precise terms in the following steps:

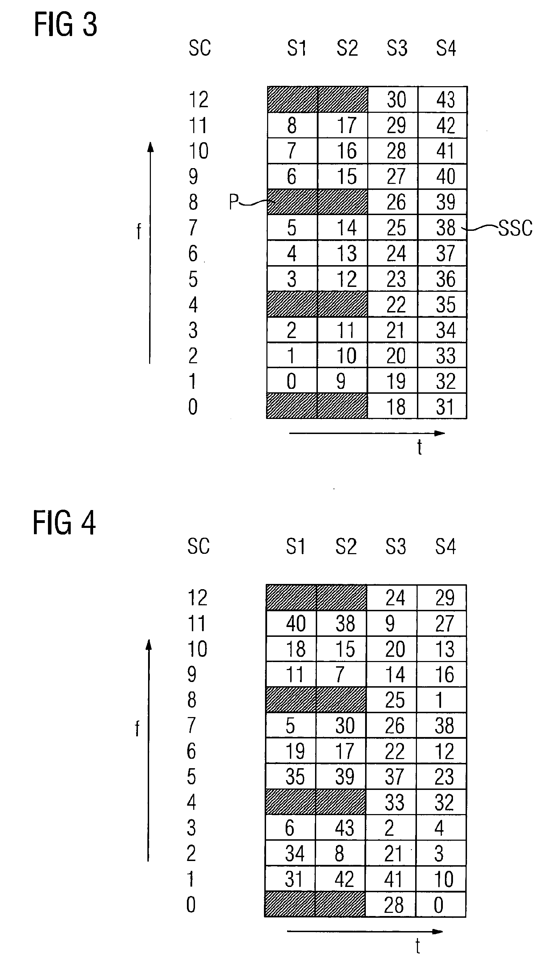

1. Create a numbering, i, with elements {0..N-1}, where N is the total number of independent symbol number/sub-carrier cells (N=100 in the example of FIG 1, N=64 in the example of FIG 2 and N=44 in the example of FIGs 3 and 4). Determine the associated set of sub-carrier frequencies, f, with elements {f(0),f(1)..f(N-1)} in units of number of sub-carriers from the minimum frequency sub-carrier. The ordering is arbitrary but the most convenient ordering runs up through the available sub-carriers SC in the first OFDM symbol S1 then up through the available sub-carriers SC in the second OFDM symbol S2, and so on. In the example of FIG 3 , there are 13 sub-carriers SC and 4 OFDM symbols S1 to S4. The symbols S1 to S4 are arranged in time one after another. Each symbol includes 13 bits and each bit is transported in one symbol number/sub-carrier cell SSC. The first pair of OFDM symbols S1 and S2 contain pilots P, shown shaded. The indices count up through the sub-carrier frequencies, jumping over the pilots, passing on from each OFDM symbol to the next. Each index constitutes an address of a symbol number/sub-carrier cell SSC.

2. Pseudo-randomly create a re-ordering, j, of i with elements {j(0),j(1)..j(N-1)}. From this we can determine the resulting order of frequencies, fs with entries {f(j(0)),f(j(1))..f(j(N-1))}. I.e. a random ordering, j, is created for the initial interleaver. As an example we have j = 31, 39, 21, 33, 34, 5, 2, 15, 10, 29, 32, 6, 37, 41, 27, 16, 40, 13, 7, 4, 28, 20, 24, 36, 30, 26, 25, 42, 18, 43, 14, 0, 35, 22, 1, 3, 17, 23, 38, 12, 8, 19, 9, 11 Each successive value of j is the frequency/time index to be used for each successive bit from the encoder. FIG 4 shows an illustration of the bit indices assigned to each symbol number/sub-carrier cell SSC.

Note that the order of the bit position in frequency and time is the *inverse* of the order j. Thus we see that, for example, the first bit is assigned to the lowest frequency on the last OFDM symbol (index 0). We can understand this because, the first value of j is 31. In FIG 3, the position of symbol number/sub-carrier cell SSC 31 is on the lowest frequency on the last OFDM symbol S4. Similarly, the second bit(index 1) is assigned to the ninth frequency of the last OFDM symbol S4. The third bit (index 2) is assigned to the fourth frequency on the third OFDM symbol S3 and so on.

Taking the sequence of bits in order we can now examine the frequencies and times that they occupy. For example, we consider the first 10 bits, i.e. bit number 0 to 9 (in a later step we consider the 10 bits from bit number 1 to 10, and so on). The resulting frequencies and times are shown in the following table, where the time value corresponds to the symbol number.

| Bit Number | Frequency | Time |
| --- | --- | --- |
| 0 | 0 | 3 |
| 1 | 8 | 3 |
| 2 | 3 | 2 |
| 3 | 2 | 3 |
| 4 | 3 | 3 |
| 5 | 7 | 0 |
| 6 | 3 | 0 |
| 7 | 9 | 1 |
| 8 | 2 | 1 |
| 9 | 11 | 2 |

The frequencies are the *absolute* frequencies - i.e. they correspond to the column of numbers to the right of the frequency arrow in FIG 3 and 4. The frequencies in the column are those frequencies over the 10 bits for which the spread should ideally be as great as possible. When we swap entries for frequencies, we carry with those entries their associated times.

3. We seek to make the spread of frequencies over the period of the memory of the code, S, as uniform as possible. For this we will re-use the generic interleaver over the different bit positions within each QAM symbol so this uniformity must be maximised over all sets of S bits defined cyclically over all available sub-carriers and symbols. Let $j_{k.s}^{T}$ be the set of S indices from $j(\mod(k-((S-1)/2),N))$ to $j(\mod(k+((S-1)/2),N))$, with entries $\left\{ j_{k.s}^{T}(0)..j_{k.s}^{T}(S-1) \right\}$ assuming that S is odd. We then obtain the set of frequencies $f_{k.s}^{T}$ with elements $\left\{ f(j_{k.s}^{T}(0)), f(j_{k.s}^{T}(1))..f(j_{k.s}^{T}(S-1)) \right\}$.

For every value of $k$, we want to maximise the spread of frequencies in $f_{k.s}^{T}$, where k represents the symbol time.

4. For each value of $k$, we compute a metric for the spread of frequencies in $f_{k.s}^{T}$ as follows: First sort the frequencies into ascending order to obtain $f_{k,S}^{TSorted}$. We also define a set of S frequencies regularly spaced over the full available bandwidth, $f_{REF}$. Using this we compute the sum square difference as a frequency spread metric:

$$M(k) = \sum_{i=0}^{S-1}(f_{k,S}^{TSorted}(i) - f_{REF}(i) - \overline{f_{k,S}^{TSorted} - f_{REF}})^{2}.$$ The smaller the metric value, the more uniformly the frequencies are spread over the interval, $S$. The complete set of metrics is vector $M$.

5. Search over all entries in vector $M$ for the largest entry. This is the position in the interleaver sequence that is currently in the most need of improvement. Once this is found, also find the entry in this expression for $M(k)$ that is largest. For example, M(2) my be the largest metric of all metrics. Within the sub-carriers of symbol time k=2, for example, the fourth bit has the largest distance to the fourth reference frequency. This is the entry, for which a change could most benefit the spread of frequencies for the selected value of $k$. Once this has been found, randomly select another entry in the sequence, $j$ and swap their positions e.g. the fourth bit position of the third column in FIG 1, i.e. bit "1" is swapped with randomly determined bit "33" meaning that f(j(1)) is swapped with f(j(33)). Thus, in the wording of the claims a new set of second positions of the sub-carriers is generated. Next re-compute vector $M$ following the change, i.e on the basis of the new set of second positions of the sub-carriers. Note that it is only necessary to re-calculate the $S$ values around both the swapped positions. In the example of FIG 2 distance $d_1$ is the largest one. Thus, sub-carrier $f_{12}$ should be swapped randomly.

6. If the minimum value of vector $M$ has reduced then retain the change. If not then try with a different randomly selected swap-value. Once the minimum value has reduced, the process of step 5 can be repeated for the position of the new minimum value. The above steps should be continued for a large number of repetitions.

The above process is directly applicable to modulation that encodes a single bit in every symbol number/sub-carrier cell. The process can be extended to larger constellation sizes. Suppose we have a constellation size of $CS$. This can encode $Q=\log_2(CS)$ bits in each symbol. Typically these Q bits will have different reliabilities depending on the distances between constellation points that affect each bit. A good interleaver will mix the different reliability bits over the period of the memory of the code.

The proposed extension to the interleaver generation procedure to allow for >1bps/Hz modulation is as follows. First perform the previous algorithm based on 1 bit in every symbol number/sub-carrier cell. Also provide an ordering of the bits encoded in each symbol/sub-carrier cell. For example, a good ordering for 64 QAM might be encoded for the bits on the I channel first in order most reliable, least reliable and medium reliable and then repeat the process for the bits on the Q channel. The ordering is then repeated enough times for one bit to be available in each of the symbol/sub-carrier cells.

On a first pass each successive bit at the output of the encoder is assigned to successive symbol number/sub-carrier cells from the initial interleaver generation algorithm with a modulation bit position derived from the repeated ordering described above. Upon completion of this process the process is repeated, this time using a bit cyclical rotation of the repeated pattern of bit assignments. This is repeated $Q$ times, until every bit position in every symbol number/sub-carrier cell has been assigned.

This description of the algorithm does not exclude alternatives, provided the fundamental principle is retained. Considered alternatives include:

- Generate the metric without subtracting the mean of the distances.
- Use a spread of reference frequencies that does not extend to the edges of the available band. This could be beneficial in providing a more uniform spread. However, the preferred approach does not extend to the edges since a large spread may be as important as a uniform spread.
- Variation in the selection of the candidate for updating are permitted. For example the algorithm may become "stuck" searching for an improvement on particular bit position. Modifications to the algorithm to detect this (e.g. exceeding a threshold of unsuccessful attempts to reduce the metric associated with that bit position) might, for example, randomly select from other bit positions whose metric is either at or close to the maximum metric value.

Advantageously, the method for generating an interleaver described above provides excellent frequency spread across the memory of the code. It allows the automatic generation of an interleaver for any burst structure regardless of how irregular.

## Claims

1. Method of optimizing a spread of sub-carriers (SC) within an overall frequency band used to modulate a set of contiguous bits for transmission of a plurality of symbols (S1 to S4), the overall frequency band being divided into a pregiven number of consecutively positioned frequency sub-bands (1), and each sub-carrier being assigned to one of said frequency sub-bands, including

   - step a: providing a plurality of symbol number/sub-carriers cells (SSC) each assigned to a specific symbol number of said symbols (S1 to S4) and a specific one of said sub-carriers (SC),
   - step b: randomly assigning one of a pregiven number of bits to one of said symbol number/sub-carriers cells (SSC) each, thus obtaining a first set of symbol number/sub-carriers cells for the pregiven number of bits, wherein each of said bits has its own specific position within the overall frequency band,
   - step c: computing a first metric (M) of spread of the positions of the bits within the overall frequency band for the first set of symbol number/sub-carriers cells (SSC),
   - step d: swapping the symbol number/sub-carriers cell (SSC) of one of said bits randomly with another one of said symbol number/sub-carriers cells (SSC) thus obtaining a second set of symbol number/sub-carriers cells for the pregiven number of bits,
   - step e: computing a second metric of spread of the positions of the bits within the overall frequency band for the second set of symbol number/sub-carriers cells(SSC),
   - step f: using said second set of symbol number/sub-carriers cells (SSC) if the second metric represents a more uniform spread of the sub-carriers within the overall frequency band than the first metric, otherwise using said first set of symbol number/sub-carriers cells.

2. Method according to claim 1, wherein the steps c to f are repeated.

3. Method according to claim 1 or 2, wherein for computing the metrics of spread in steps c and e a set of regularly spaced reference frequencies (2) is provided, the sub-carriers are positioned in a frequency ascending order and the respective metric is computed on the basis of a sum of values relating to distances ($d_1$ to $d_8$), each distance representing the interval between one of said sub-carriers and a corresponding one of said reference frequencies (2).

4. Method according to claim 3, wherein said set of reference frequencies is provided starting and/or ending with a gap to the respective edge of the overall frequency band.

5. Method according to claim 3 or 4, wherein for obtaining the sum of values a mean of all distances ($d_1$ to $d_8$) is subtracted from each distance.

6. Method according to claim 1 or 2, wherein for computing the metrics of spread in steps c and e a mean frequency of said overall frequency band is provided and the metric is computed on the basis of the standard deviation of the sub-carriers from the mean frequency.

7. Coding method including a method according to one of the preceding claims, wherein each sub-carrier ($f_{12}$, $f_{17}$, $f_{25}$, $f_{29}$, $f_{42}$, $f_{49}$, $f_{59}$, $f_{62}$) is assigned to a separate bit of a code, respectively.

8. Coding method according to claim 7, wherein the code is used for OFDM modulation.

9. Interleaving device for optimizing a spread of sub-carriers (SC) within an overall frequency band used to modulate a set of contiguous bits for transmission of a plurality of symbols (S1 to S4), the overall frequency band being divided into a pregiven number of consecutively positioned frequency sub-bands (1), and each sub-carrier being assigned to one of said frequency sub-bands, the interleaving device being designed to carry out the following steps

- step a: providing a plurality of symbol number/sub-carriers cells (SSC) each assigned to a specific symbol number of said symbols and a specific one of said sub-carriers,
- step b: randomly assigning one of a pregiven number of bits to one of said symbol number/sub-carriers cells (SSC) each, thus obtaining a first set of symbol number/sub-carriers cells (SSC) for the pregiven number of bits, wherein each of said bits has its own specific position within the overall frequency band,
- step c: computing a first metric of spread of the positions of the bits within the overall frequency band for the first set of symbol number/sub-carriers cells (SSC),
- step d: swapping the symbol number/sub-carriers cell (SSC) of one of said bits randomly with another one of said symbol number/sub-carriers cells (SSC) thus obtaining a second set of symbol number/sub-carriers cells for the pregiven number of bits,
- step e: computing a second metric of spread of the positions of the bits within the overall frequency band for the second set of symbol number/sub-carriers cells (SSC),
- step f: using said second set of symbol number/sub-carriers cells (SSC) if the second metric represents a more uniform spread of the sub-carriers within the overall frequency band than the first metric, otherwise using said first set of symbol number/sub-carriers cells.

10. Coder for providing a convolutional code, including an interleaving device according to claim 9, wherein the pregiven number of bits corresponds to the span of the memory of the code.

**Amended claims in accordance with Rule 137(2) EPC.**

1. Method of optimizing a spread of sub-carriers (SC) within an overall frequency band used to modulate a set of contiguous bits for transmission of a plurality of symbols (S1, S2, S3, S4), the overall frequency band being divided into a pregiven number of consecutively positioned frequency sub-bands (1), and each sub-carrier being assigned to one of said frequency sub-bands, including

- step a: providing a plurality of symbol number/sub-carriers cells (SSC) each assigned to a specific symbol number of said symbols (S1, S2, S3, S4) and a specific one of said sub-carriers (SC),
- step b: randomly assigning one of the set of contiguous bits to one of said symbol number/sub-carriers cells (SSC) each, thus obtaining a first set of symbol number/sub-carriers cells for the set of contiguous bits, wherein each of said bits has its own specific position within the overall frequency band,
- step c: computing for each symbol (S1, S2, S3, S4) a first metric (M) of spread of the positions of the bits within the overall frequency band for the first set of symbol number/sub-carriers cells (SSC),

- step d: swapping the symbol number/sub-carriers cell (SSC) of one of said bits randomly with another one of said symbol number/sub-carriers cells (SSC) thus obtaining a second set of symbol number/sub-carriers cells for the set of contiguous bits,
- step e: computing for each symbol (S1, S2, S3, S4) a second metric of spread of the positions of the bits within the overall frequency band for the second set of symbol number/sub-carriers cells(SSC),
- step f: using said second set of symbol number/sub-carriers cells (SSC) if the second metric represents a more uniform spread of the sub-carriers within the overall frequency band than the first metric, otherwise using said first set of symbol number/sub-carriers cells.

2. Method according to claim 1, wherein the steps c to f are repeated.

3. Method according to claim 1 or 2, wherein for computing the metrics of spread in steps c and e a set of regularly spaced reference frequencies (2) is provided, the sub-carriers are positioned in a frequency ascending order and the respective metric is computed on the basis of a sum of values relating to distances (d1, d2, d3, d4, d5, d6, d7, d8), each distance representing the interval between one of said sub-carriers and a corresponding one of said reference frequencies (2).

4. Method according to claim 3, wherein said set of reference frequencies is provided starting and/or ending with a gap to the respective edge of the overall frequency band.

5. Method according to claim 3 or 4, wherein for obtaining the sum of values a mean of all distances (d1, d2, d3, d4, d5, d6, d7, d8) is subtracted from each distance.

6. Method according to claim 1 or 2, wherein for computing the metrics of spread in steps c and e a mean frequency of said overall frequency band is provided and the metric is computed on the basis of the standard deviation of the sub-carriers from the mean frequency.

7. Coding method including a method according to one of the preceding claims, wherein each sub-carrier (f12, f17, f25, f29, f42, f49, f59, f62) is assigned to a separate bit of a code, respectively.

8. Coding method according to claim 7, wherein the code is used for OFDM modulation.

9. Interleaving device for optimizing a spread of sub-carriers (SC) within an overall frequency band used to modulate a set of contiguous bits for transmission of a plurality of symbols (S1, S2, S3, S4), the overall frequency band being divided into a pregiven number of consecutively positioned frequency sub-bands (1), and each sub-carrier being assigned to one of said frequency sub-bands, the interleaving device being designed to carry out the following steps

- step a: providing a plurality of symbol number/sub-carriers cells (SSC) each assigned to a specific symbol number of said symbols and a specific one of said sub-carriers,
- step b: randomly assigning one of the set of contiguous bits to one of said symbol number/sub-carriers cells (SSC) each, thus obtaining a first set of symbol number/sub-carriers cells (SSC) for the set of contiguous bits, wherein each of said bits has its own specific position within the overall frequency band,
- step c: computing for each symbol (S1, S2, S3, S4) a first metric of spread of the positions of the bits within the overall frequency band for the first set of symbol number/sub-carriers cells (SSC),
- step d: swapping the symbol number/sub-carriers cell (SSC) of one of said bits randomly with another one of said symbol number/sub-carriers cells (SSC) thus obtaining a second set of symbol number/sub-carriers cells for the set of contiguous bits,
- step e: computing for each symbol (S1, S2, S3, S4) a second metric of spread of the positions of the bits within the overall frequency band for the second set of symbol number/sub-carriers cells (SSC),
- step f: using said second set of symbol number/sub-carriers cells (SSC) if the second metric represents a more uniform spread of the sub-carriers within the overall frequency band than the first metric, otherwise using said first set of symbol number/sub-carriers cells.

10. Coder for providing a convolutional code, including an interleaving device according to claim 9.

EP 2 884 667 A1

# FIG 1

| f(j(96)) | f(j(97)) | f(j(98)) | | f(j(94)) | f(j(95)) |
|----------|----------|----------|---|----------|----------|
| f(j(97)) | f(j(98)) | f(j(99)) | | f(j(95)) | f(j(96)) |
| f(j(98)) | f(j(99)) | f(j(0))  | | f(j(96)) | f(j(97)) |
| f(j(99)) | f(j(0))  | f(j(1))  | | f(j(97)) | f(j(98)) |
| f(j(0))  | f(j(1))  | f(j(2))  | | f(j(98)) | f(j(99)) |
| f(j(1))  | f(j(2))  | f(j(3))  | | f(j(99)) | f(j(0))  |
| f(j(2))  | f(j(3))  | f(j(4))  | | f(j(0))  | f(j(1))  |
| f(j(3))  | f(j(4))  | f(j(5))  | | f(j(1))  | f(j(2))  |
| f(j(4))  | f(j(5))  | f(j(6))  | | f(j(2))  | f(j(3))  |

k →

M(0)  M(1)  M(2)            M(98)  M(99)

FIG 2

EP 2 884 667 A1

## FIG 3

| SC | S1 | S2 | S3 | S4 |
|---|---|---|---|---|
| 12 | ▨ | ▨ | 30 | 43 |
| 11 | 8 | 17 | 29 | 42 |
| 10 | 7 | 16 | 28 | 41 |
| 9 | 6 | 15 | 27 | 40 |
| 8 | P ▨ | ▨ | 26 | 39 |
| 7 | 5 | 14 | 25 | 38 — SSC |
| 6 | 4 | 13 | 24 | 37 |
| 5 | 3 | 12 | 23 | 36 |
| 4 | ▨ | ▨ | 22 | 35 |
| 3 | 2 | 11 | 21 | 34 |
| 2 | 1 | 10 | 20 | 33 |
| 1 | 0 | 9 | 19 | 32 |
| 0 | ▨ | ▨ | 18 | 31 |

f ↑   t →

## FIG 4

| SC | S1 | S2 | S3 | S4 |
|---|---|---|---|---|
| 12 | ▨ | ▨ | 24 | 29 |
| 11 | 40 | 38 | 9 | 27 |
| 10 | 18 | 15 | 20 | 13 |
| 9 | 11 | 7 | 14 | 16 |
| 8 | ▨ | ▨ | 25 | 1 |
| 7 | 5 | 30 | 26 | 38 |
| 6 | 19 | 17 | 22 | 12 |
| 5 | 35 | 39 | 37 | 23 |
| 4 | ▨ | ▨ | 33 | 32 |
| 3 | 6 | 43 | 2 | 4 |
| 2 | 34 | 8 | 21 | 3 |
| 1 | 31 | 42 | 41 | 10 |
| 0 | ▨ | ▨ | 28 | 0 |

f ↑   t →

**EP 2 884 667 A1**

<table>
<tr><td colspan="2">Europäisches Patentamt<br>European Patent Office<br>Office européen des brevets</td><td>**EUROPEAN SEARCH REPORT**</td><td>Application Number<br>EP 13 19 7238</td></tr>
</table>

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 7 539 463 B2 (HIMAYAT NAGEEN [US] ET AL) 26 May 2009 (2009-05-26)<br>* figure 5A *<br>* column 11, line 55 - column 12, line 9 * | 1,7,9,10 | INV.<br>H03M13/27<br>H04L1/00<br>H04L27/26<br>H04L5/00 |
| A | CHUANXUE JIN ET AL: "Iterative Random Interleaver Design for OFDM System", CIRCUITS, COMMUNICATIONS AND SYSTEMS, 2009. PACCS '09. PACIFIC-ASIA CONFERENCE ON, IEEE, PISCATAWAY, NJ, USA, 16 May 2009 (2009-05-16), pages 85-87, XP031526067, ISBN: 978-0-7695-3614-9<br>* figure 2 *<br>* Section II.C * | 1,7,9,10 | |
| A | ISABELLE SIAUD ET AL: "Interleaving based resource allocation algorithms for Multi Gigabit Wireless OFDM systems", CROSS LAYER DESIGN (IWCLD), 2011 THIRD INTERNATIONAL WORKSHOP ON, IEEE, 30 November 2011 (2011-11-30), pages 1-5, XP032088214, DOI: 10.1109/IWCLD.2011.6123086 ISBN: 978-1-4577-1568-6<br>* Section 1. Introduction *<br>* Section 2. System Proposal * | 1,7,9,10 | TECHNICAL FIELDS SEARCHED (IPC)<br><br>H03M<br>H04L |
| A | WO 2007/066044 A2 (FRANCE TELECOM [FR]; SIAUD ISABELLE [FR]; ULMER-MOLL ANNE-MARIE [FR]) 14 June 2007 (2007-06-14)<br>* paragraph [0042] - paragraph [0046] *<br>* figures 3,4 * | 1,7,9,10 | |
| A | EP 1 608 075 A2 (TOSHIBA KK [JP]) 21 December 2005 (2005-12-21)<br>* figures 1,2 *<br>* paragraphs [0009], [0010] * | 1,7,9,10 | |

The present search report has been drawn up for all claims

| Place of search | Date of completion of the search | Examiner |
|---|---|---|
| Berlin | 11 June 2014 | Chave, Julien |

**ANNEX TO THE EUROPEAN SEARCH REPORT
ON EUROPEAN PATENT APPLICATION NO.** EP 13 19 7238

This annex lists the patent family members relating to the patent documents cited in the above-mentioned European search report.
The members are as contained in the European Patent Office EDP file on
The European Patent Office is in no way liable for these particulars which are merely given for the purpose of information.

11-06-2014

| Patent document cited in search report | | Publication date | Patent family member(s) | | Publication date |
|---|---|---|---|---|---|
| US 7539463 | B2 | 26-05-2009 | US | 2006223460 A1 | 05-10-2006 |
| | | | US | 2010041351 A1 | 18-02-2010 |
| | | | US | 2012087398 A1 | 12-04-2012 |
| | | | US | 2013010886 A1 | 10-01-2013 |
| WO 2007066044 | A2 | 14-06-2007 | CN | 101336534 A | 31-12-2008 |
| | | | EP | 1969792 A2 | 17-09-2008 |
| | | | FR | 2894413 A1 | 08-06-2007 |
| | | | JP | 5209488 B2 | 12-06-2013 |
| | | | JP | 2009518914 A | 07-05-2009 |
| | | | KR | 20080075548 A | 18-08-2008 |
| | | | US | 2009274035 A1 | 05-11-2009 |
| | | | WO | 2007066044 A2 | 14-06-2007 |
| EP 1608075 | A2 | 21-12-2005 | CN | 1778048 A | 24-05-2006 |
| | | | EP | 1608075 A2 | 21-12-2005 |
| | | | GB | 2415336 A | 21-12-2005 |
| | | | JP | 2008503110 A | 31-01-2008 |
| | | | US | 2005283705 A1 | 22-12-2005 |
| | | | WO | 2005125018 A1 | 29-12-2005 |

EPO FORM P0459

For more details about this annex : see Official Journal of the European Patent Office, No. 12/82